# FASCICULE DE BREVET EUROPEEN

(11) **EP 0 562 897 B1**
(45) Date de publication et mention de la délivrance du brevet: **07.07.1999**
(21) Numéro de dépôt: 93400590.1
(22) Date de dépôt: 08.03.1993
(51) Int. Cl.: C07F 5/02, C07C 25/00, C07C 43/257, C08F 4/52, C08F 16/12, C08G 59/68, C07F 17/02

(54) **Borates d'onium ou de complexe organométallique amorceurs cationiques de polymérisation**
Borate mit Kationen aus der Gruppe von Onium oder organometallischen Komplexen, als kationische Polymerisationsinitiatoren
Borates with cations selected from the group of onium or organometallic complexes, as cationic polymerisation initiators

(30) Priorité: 23.03.1992 FR 9203440
(43) Date de publication de la demande: 29.09.1993
(73) Titulaire: RHODIA CHIMIE, 92408 Courbevoie Cédex (FR)
(72) Inventeur: Castellanos, Frédéric, F-68200 Mulhouse (FR); Cavezzan, Jacques, F-69100 Villeurbanne (FR); Fouassier, Jean-Pierre, F-68790 Morschwiller-le-Bas (FR); Priou, Christian, F-69100 Villeurbanne (FR)
(74) Mandataire: Trolliet, Maurice

(56) Documents cités:
- EP-A- 0 421 659
- EP-A- 0 442 635
- EP-A- 0 468 651
- EP-A- 0 490 269
- EP-A- 0 492 282
- WO-A-90/11303
- WO-A-91/14713
- US-A- 4 992 571
- DIE MAKROMOLEKULARE CHEMIE, RAPID COMMUNUNICATIONS vol. 12, 1991, pages 663 - 667 PELLECCHIA, C. ET AL
- CHEMICAL ABSTRACTS, vol. 113, 1990, Columbus, Ohio, US; abstract no. 32008b, FUKUI, T. page 539 ;
- JOURNAL OF THE AMERICAN CHEMICAL SOCIETY vol. 113, 1991, pages 8570 - 8571 CHIEN, J.C.W. ET AL.
- JOURNAL OF THE AMERICAN CHEMICAL SOCIETY vol. 113, 1991, pages 7823 - 7825 ZOU, C. ET AL.
- JOURNAL OF ORGANOMETALLIC CHEMISTRY vol. 2, 1964, pages 245 - 250 MASSEY, A.G. ET AL.
- CHEMICAL ABSTRACTS, vol. 114, 1991, Columbus, Ohio, US; abstract no. 164396g, YANG, X. ET AL. page 795 ;

## Description

La présente invention a pour objet de nouveaux borates d'onium ou de complexe organométallique amorceurs cationiques de polymérisation, leur procédé de préparation et leur utilisation pour la polymérisation ou la réticulation de monomères ou de polymères fonctionnels par activation photochimique ou sous faisceau d'électrons.

Les sels d'onium ou de complexes organométalliques sont bien connus comme amorceurs de polymérisation cationique de monomères ou de polymères à groupements fonctionnels par exemple de type époxy, vinyléther (brevets US-A-4.069.054 ; US-A-4.450.360 ; US-A-4.576.999 ; US-A-4.640.967 ; brevet canadien n°1.274.646 ; demande européenne EP-A- 203 829).

Il a été constaté que les meilleurs résultats sont obtenus lorsque l'anion du sel amorceur est SbF₆⁻ ; les sels amorceurs contenant ce type d'anion présentent toutefois des risques de toxicité.

Il est également connu d'utiliser des perfluorotétraphénylborates de ferrocénium du type bis(η⁵-cyclopentadiényle) Fe⁺ tétrakis(pentafluoroborate) pour engendrer des catalyseurs du type Ziegler-Natta, catalyseurs qui sont ensuite mis en oeuvre pour polymériser des monomères vinyliques (demandes de brevets EP-A-481 480 ; EP-A-468 651 ; EP-A-418 044 ; EP-A-468 537 ; EP-A-421 659 ; EP-A-277 004 ; Makromol. Chem., Rapid Commun. 12, 663-667, 1991; Organometallics 1991, 10, 840-842) ; on a constaté que les perfluorotétraphénylborates de ferrocénium du type bis(η⁵-cyclopentadiényle) Fe⁺ tétrakis(pentafluoroborate) ne sont pas des photoamorceurs.

La Demanderesse a trouvé de nouveaux sels photoamorceurs contenant un anion de nucléophilie voisine de celle de SbF₆⁻ et ne présentant pas les inconvénients liés à ce dernier.

Selon l'invention il s'agit de borates d'onium d'un élément des groupes 15 à 17 de la classification périodique [Chem. & Eng. News, vol 63, N°5, 26 du 4 Février 1985] ou d'un complexe organométallique d'un élément des groupes 4 à 10 de la classification périodique (même référence), caractérisés en ce que l'entité cationique est choisie parmi :
(1) - les sels d'onium de formule I

   [(R¹)ₙ- A -(R²)ₘ]⁺ (I)

   formule dans laquelle :
   . A représente un élément des groupes 15 à 17 choisi parmi I, S et Se,
   . R¹ représente un radical aryle carbocyclique ou hétérocyclique en C₆-C₂₀, ledit radical hétérocyclique pouvant contenir comme hétéroéléments de l'azote ou du soufre,
   . R² représente R¹ ou un radical alkyle ou alkényle linéaire ou ramifié en C₁-C₃₀;
   lesdits radicaux R¹ et R² étant éventuellement substitués par un groupement alcoxy en C₁-C₂₅, alkyle en C₁-C₂₅, nitro, chloro, bromo, cyano, carboxy, ester ou mercapto,
   . n est un nombre entier allant de 1 à v+1, v étant la valence de l'élément A,
   . m est un nombre entier allant de 0 à v-1 avec n+m = v+1 ;
(2) - les sels d'oxoisothiochromanium décrits dans la demande de brevet WO-A-90/11303 possédant la formule : 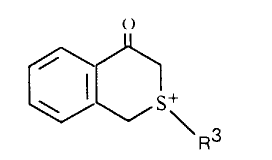 où le radical R³ représente un radical alkyle, linéaire ou ramifié, en C₁-C₂₀ ;
(3) - les sels organométalliques de formule (Il)

   (L¹L²L³M)^{+q} (II)

   formule dans laquelle :
   . M représente un métal du groupe 4 à 10, sélectionné parmi le fer, le manganèse, le chrome et le cobalt,
   . L¹ représente 1 ligand lié au métal M par des électrons π, ligand choisi parmi les ligands η³-alkyl, η⁵-cyclopentadiényl et η⁷-cycloheptatriényl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 3 à 8 électrons π ;
   . L² représente 1 ligand lié au métal M par des électrons π, ligand choisi parmi les ligands η⁷-cycloheptatriényl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 6 ou 7 électrons π ;
   . L³ représente de 0 à 3 ligands identiques ou différents liés au métal M par des électrons σ, ligand(s) choisi(s) parmi CO et NO₂⁺ ; la charge électronique totale q du complexe à laquelle contribuent L¹, L² et L³ et la charge ionique du métal M étant positive et égale à 1 ou 2 ;
et en ce que l'entité anionique borate a pour formule :

[B Xₐ R_{b}]⁻

formule dans laquelle :
- a et b sont des nombres entiers allant de 0 à 4 avec a + b = 4
- les symboles X représentent
   . un atome d'halogène (chlore, fluor) avec a = 0 à 3
   . une fonction OH avec a = 0 à 2
- les symboles R sont identiques ou différents et représentent
   . un radical phényle substitué par au moins un groupement électroattracteur choisi parmi CF₃, NO₂, CN ou par au moins 2 atomes de fluor, ce lorsque l'entité cationique est un onium d'un élément des groupes 15 à 17,
   . un radical phényle substitué par au moins un élément ou un groupement électroattracteur choisi parmi un atome de fluor, CF₃, NO₂, CN, ce lorsque l'entité cationique est un complexe organométallique d'un élément des groupes 4 à 10,
   . un radical aryle contenant au moins deux noyaux aromatiques tel que par exemple biphényle, naphtyle, éventuellement substitué par au moins un élément ou un groupement électroattracteur choisi parmi un atome de fluor, CF₃, NO₂, CN, quelle que soit l'entité cationique.

Dans l'article J. Chem. Soc., Chemical Communications, 1989, pages 47-50, où l'on explore la réactivité de nouveaux composés du xénon, il est décrit un produit de réarrangement consistant dans le tétrakis (pentafluorophényl) borate de (pentafluorophényl) iodonium. Ce sel d'onium particulier n'est pas sélectionné dans les composés de formule (I) présentés ci-avant, et il n'est pas présenté comme ayant une activité catalytique dans un domaine quelconque.

Comme exemple d'anion borate on peut citer :
[B(C₆F₅)₄]⁻ [B(C₆H₄CF₃)₄]⁻
[(C₆F₅)₂BF₂]⁻ [C₆F₅BF₃]⁻ [B(C₆H₃F₂)₄]⁻

Les sels d'onium de formule I sont décrits dans de nombreux documents notamment dans les brevets US-A-4.026.705 ; US-A-4.032.673 ; US-A-4.069.056 ; US-A.4.136.102 ; US.A-4.173.476.

On peut citer tout particulièrement les cations suivants :
[(Φ)₂I]⁺ [C₈H₁₇-O-Φ-I-Φ]⁺
[C₁₂H₂₅-Φ-I-Φ]⁺ [(C₈H₁₇-O-Φ)₂I]⁺ [(C₈H₁₇)-O-Φ-I-Φ)]⁺
[(Φ)₃ S]⁺ [(Φ)₂-S-Φ-O-C₈H₁₇]⁺
[Φ-S-Φ-S(Φ)₂]⁺ [(C₁₂H₂₅-Φ)₂I]⁺

Les sels organométalliques de formule (Il) figurent parmi ceux décrits dans les brevets US-A-4.973.722 ; US-A-4.992.572, les demandes de brevet européen EP-A- 203.829 ; EP-A-323.584 et EP-A-354.181.

Parmi ces sels organométalliques on peut citer tout particulièrement :
. le (η⁵-cyclopentadiényle) (η⁶-toluène) Fe⁺
. le (η⁵-cyclopentadiényle) (η⁶-méthyl1-naphtalène) Fe⁺
. le (η⁵-cyclopentadiényle) (η⁶-cumène) Fe⁺
. le bis (η⁶-mesitylène) Fe⁺
. le bis (η⁶-benzène)Cr⁺

Comme exemple d'amorceurs de l'invention, on peut citer :
[(Φ)₂I]⁺, [B (C₆F₅)₄]⁻ [C₈H₁₇-O-Φ-I-Φ]⁺, [B(C₆F₅)₄]⁻
[C₁₂H₂₅-Φ-I-Φ]⁺, [B(C₆F₅)₄]⁻ [(C₈H₁₇-O-Φ)₂I]⁺, [B(C₆F₅)₄]⁻
[(C₈H₁₇)-O-Φ-I-Φ)]⁺, [B (C₆F₅)₄]⁻ [(Φ)₃ S]⁺, [B(C₆F₅)₄]⁻
[(Φ)₂ S-Φ-O-C₈H₁₇]⁺, [B (C₆H₄CF₃)₄]⁻ [(C₁₂H₂₅-Φ)₂I]⁺, [B(C₆F₅)₄]⁻
. le (η⁵-cyclopentadiènyle) (η⁶-toluène) Fe⁺, [B (C₆F₅)₄]⁻
. le (η⁵-cyclopentadiènyle) (η⁶-méthyl1-naphtalène) Fe⁺, [B (C₆F₅)₄]⁻
. le (η⁵-cyclopentadiènyle) (η⁶-cumène) Fe⁺, [B (C₆F₅)₄]⁻

L'entité cationique de type oxoisothiochromonium, entrant dans la formulation de nouveaux borates cationiques selon l'invention, correspond à la structure D1 qui est définie à la page 14 de la demande WO-A-90/11303 et possède la formule : 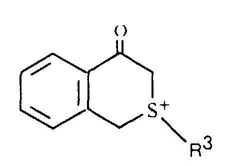 où le radical R³ (qui correspond au symbole R¹ figurant dans ladite demande WO) représente un radical alkyle, linéaire ou ramifié, en C₁-C₂₀. Comme sels d'oxoisothiochromanium qui conviennent bien, on citera notamment le sel de sulfonium de 2-éthyl-4-oxoisothiochromanium ou de 2-dodécyl-4-oxoisothiochromanium.

Les sels amorceurs faisant l'objet de la présente invention peuvent être préparés par réaction d'échange entre un sel de l'entité cationique (halogénure tel que par exemple chlorure, iodure, hexafluorophosphate, tetrafluoroborate, tosylate) avec un sel de métal alcalin (sodium, lithium, potassium) de l'entité anionique.

Les conditions opératoires (notamment quantités respectives de réactifs, choix des solvants, durée, température, agitation) sont à la portée de l'homme de l'art ; celles-ci doivent permettre de récupérer le sel amorceur recherché sous forme solide par filtration du précipité formé ou sous forme huileuse par extraction à l'aide d'un solvant approprié.

Les sels de métal alcalin de l'entité anionique peuvent être préparés de manière connue, par réaction d'échange entre un composé halogénoboré et un composé organométallique (par exemple : magnésien, lithien, stannique) portant les groupements hydrocarbonés désirés, en quantité stoechiométrique, suivie éventuellement d'une hydrolyse à l'aide d'une solution aqueuse d'halogénure de métal alcalin ; ce type de synthèse est par exemple décrit dans "J. of organometallic Chemistry" vol. 178, pages 1-4,1979 ; "J.A.C.S" 82, 1960, 5298 ; "Anal. Chem. Acta" 44, 1969, 175-183 ; brevets US-A- 4.139.681 et DE-A-2.901.367 ; "Zh. Org. Khim." Vol. 25, N°5 - pages 1099-1102 Mai 1989.

Le mode préparatoire des sels de l'entité cationique de formule (Il) est décrit notamment dans D. ASTRUC, Tetrahedron Letters, 36, page 3437 (1973) ; D. ASTRUC, Bull. Soc. Chim. Fr., 1-2, page 228 (1976) ; D. ASTRUC, Bull. Soc. Chim. Fr., 11-12, page 2571 (1975) ; D. ASTRUC, CR Acad.Sc. Paris, série C, 272, page 1337 (1971) ; A.N. NESMEYANOV et coll., Izves. Akad. Nauk SSSR, ser.Khim., 7, page 1524 (1969) ; A.N. NESMEYANOV et coll., Dokl. Akad. Nauk SSSR, 160(6), page 1327 (1965) ; A.N. NESMEYANOV et colt., Dokl. Akad. Nauk SSSR, 149(3), page 615 (1963).

Les sels amorceurs faisant l'objet de l'invention peuvent être mis en oeuvre pour polymériser ou réticuler par activation photochimique (notamment sous rayonnement ultraviolet) ou sous faisceau d'électrons des monomères ou des polymères portant des groupements fonctionnels tels que par exemple époxy, vinyléther. Les borates de complexes organométalliques peuvent en outre être utilisés comme amorceurs de polymérisation par voie thermique.

Les exemples suivants sont donnés à titre illustratif et ne peuvent être considérés comme une limite de l'invention.

### Exemple 1: tétrakis(pentafluorophényl)borate de diphényliodonium [(Φ)₂I]⁺, [B(C₆F₅)₄]⁻

### - Préparation de tétrakis(pentafluorophényl)borate de lithium

On utilise un ballon tétracol de 4000 ml, équipé d'une agitation mécanique, d'un réfrigérant à eau, d'un thermomètre et d'une ampoule de coulée. Le montage est préalablement séché sous atmosphère d'argon.
On charge 1600 ml de pentane anhydre et 126,8 g (soit 0,513 mole) de bromopentafluorobenzène. L'ensemble est agité puis refroidi à -78°C à l'aide d'un bain glace carbonique/acétone.
313 ml d'une solution 1,6M de n-Butyllithium dans l'hexane est chargée dans l'ampoule de coulée puis est ajoutée goutte à goutte en 50 minutes.
Le mélange est ensuite laissé sous agitation pendant 5 heures à la température de -78°C.
125 ml d'une solution 1M de trichlorure de bore dans l'hexane sont chargés dans l'ampoule de coulée et ajoutés au milieu en 30 minutes. On retire le bain réfrigérant et on laisse revenir le mélange réactionnel à la température ambiante. On laisse ensuite sous agitation pendant 12 heures. Le mélange réactionnel est hydrolysé par addition lente de 625 ml d'eau. Les deux phases sont séparées et la phase organique est lavée par deux fractions de 125 ml d'eau. Les phases aqueuses sont réunies, puis sont extraites trois fois à l'éther (3 x 125 ml). Les phases éthérées sont rassemblées et séchées sur du sulfate de magnésium. L'éther est évaporé sous pression réduite et on récupère 101 g (soit un rendement de 99%) de tétrakis (pentafluorophényl)borate de lithium.

### - Préparation du tetrakis(pentafluorophényl)borate de diphényliodonium

Dans un erlenmeyer de 1000 ml, on dissout 7,17 g. (soit 22,6 mmoles) de chlorure de diphényliodonium dans 300 ml d'eau. On ajoute goutte à goutte 15,52 g (soit 22,6 mmoles) de tétrakis(pentafluorophényl) borate de lithium en solution dans 250 ml d'eau. Le mélange est laissé sous agitation pendant 30 minutes, puis est filtré. Le filtrat est séché sous pression réduite (133 Pa) pendant une nuit, à l'abri de la lumière. On récupère ainsi 16,33 g (soit un rendement de 75%) de tétrakis(pentafluorophényl)borate de diphényliodonium.

### Exemple 2: tetrakis (pentafluorophényl)borate de (4-octyloxyphényl) phényliodonium

[(C₈H₁₇)-O-Φ-I-Φ)]^{+,} [B(C₆F₅)₄]⁻

### - Préparation de l'octylphényléther

Dans un ballon de tricot de 500 ml, équipé d'une agitation mécanique, d'un thermomètre et d'un réfrigérant à eau, on charge 44,8 g (soit 0,477 mole) de phénol, 38,6 g (soit 0,2 mole) de n-bromooctane, 6 g de bromure de tétrabutylammonium, 26,8 g de potasse, 100 ml d'eau et 100 ml de toluène. L'ensemble est agité, puis est porté au reflux pendant 20 heures. Le mélange réactionnel est ensuite refroidi à température ambiante. Les phases sont décantées et séparées. La phase organique est lavée par 100 ml d'une solution 0,5N de soude, puis par cinq fractions de 100 ml d'eau. Elle est ensuite séchée sur sulfate de magnésium, puis le solvant est chassé sous pression réduite, à la température de 85°C.
On récupère 41,5 g (soit un rendement de 95%) de n-octylphényléther, qui peut être utilisé par la suite sans purification supplémentaire.

### - Préparation de l'hydroxytosyloxyiodobenzène

Dans un ballon de 1000 ml, équipé d'une agitation mécanique, d'un réfrigérant à eau et d'une ampoule de coulée, on charge 80,53 g (soit 0,25 mole) de iodobenzènediacétate, 300 ml d'eau et 100 ml d'acide acétique. L'ensemble est agité, et est chauffé à 40°C. On ajoute ensuite en cinq minutes 47,55 g (soit 0,25 mole) d'acide paratoluène sulfonique monohydrate par l'intermédiaire de l'ampoule de coulée. Le mélange réactionnel est maintenu à 40°C pendant deux heures, puis est refroidi à 25°C. Un précipité blanc apparait. Il est récupéré par filtration, puis est séché sous pression réduite.
On obtient 68,15 g (soit un rendement de 70%) du produit recherché.

### - Préparation du tosylate de (4-octyloxyphényl) phényliodonium

Dans un erlenmeyer de 250 ml muni d'un barreau d'agitation magnétique, on charge 22,2 g (soit 0,057 mole) d'hydroxytosyloxyiodobenzène, 9 g (soit 0,04 mole) de n-octyphényl éther, 5 ml d'acétonitrile et 1,5 ml d'acide acétique. Ce mélange est agité et est porté à la température de 40°C pendant 2 heures et 30 minutes. On ajoute ensuite 1,5 ml d'acide acétique glacial, puis on laisse 5 heures à 40°C. On laisse refroidir la masse réactionnelle et on ajoute 150 ml d'eau tout en maintenant une agitation vigoureuse. Ce mélange est ensuite agité pendant 12 heures à température ambiante, puis est décanté. La phase organique est lavée plusieurs fois par de l'eau jusqu'à ce qu'un précipité jaune apparaisse. Ce solide est récupéré par filtration, il est lavé par 50 ml d'éther, puis est séché sous vide à la température de 45°C.
On récupère ainsi 19,5 g (soit un rendement de 76%) de tosylate de (4-octyloxyphényl) phényl iodonium.

### - Préparation du tétrakis (pentafluorophényl)borate de (4-octyloxyphényl) phényliodonium

Dans un erlenmeyer de 500 ml muni d'un barreau d'agitation magnétique on dissout 5 g (soit 0,0086 mole) de tosylate de (4-octyloxyphényl) phényliodonium dans 350 ml d'acétone. A l'abri de la lumière, on ajoute 3,4 g (soit 0,0103 mole) de tétrakis(pentafluorophényl)borate de lithium en solution dans 50 ml d'acétone. Le mélange est agité pendant 48 heures, puis est filtré pour éliminer le p-toluène sulfonate de lithium formé. L'acétone est évaporée sous pression réduite et on récupère 7,98 g (soit un rendement de 92%) de tétrakis(pentafluorophényl)borate de (4-octyloxyphényl) phényl iodonium.

### Exemple 3 : tetrakis (pentafluorophényl)borate de bisdodécylphényliodonium

[(C₁₂H₂₅-Φ)₂I]^{+,} [B(C₆F₅)₄]⁻

### - Préparation du chlorure de bisdodécylphényliodonium

Dans un ballon de 1000 ml, équipé d'une agitation mécanique, d'un réfrigérant à eau et d'une ampoule coulée, on charge 100 g (soit 0,405 mole) de dodécylbenzène, 43,5 g (soit 0,203 mole) de iodate de potassium, 199,6 g d'acide acétique et 59,5 g d'anhydride acétique. Le mélange est agité puis refroidi dans un bain de glace à 0°C. On charge un mélange de 59,8 g d'acide sulfurique et de 39,86 g d'acide acétique dans l'ampoule de coulée. On ajoute en 25 minutes ce mélange à la masse réactionnelle. On laisse 18 heures sous agitation à température ambiante. On ajoute ensuite 750 ml d'eau, puis on extrait la masse réactionnelle par trois fractions d'éther (3 x 350 ml). Les phases éthérées sont rassemblées puis évaporées sous pression réduite. Le concentrat est repris par 540 ml d'une solution saturée en chlorure de sodium, puis le mélange est refroidi dans un bain de glace pendant deux heures. On récupère le produit par filtration sur verre fritté n°4. Le solide est ensuite recristallisé deux fois dans l'acétone. On récupère 69,18 g (soit un rendement de 52%) de chlorure de bisdodécylphényliodonium par filtration.

### - Préparation du tetrakis (pentafluorophényl)borate de bisdodécylphényliodonium

Dans un erlenmeyer de 1000 ml, on dissout 3,76 g de chlorure de bisdodécylphényliodonium dans 500 ml d'acétone. On ajoute ensuite goutte à goutte une solution de 5 g de tétrakis(pentafluorophényl)borate de lithium dans 100 ml d'acétone. Le mélange est laissé sous agitation pendant deux jours, à l'abri de la lumière, puis le chlorure de sodium formé est éliminé par filtration. On récupère 8 g (soit un rendement de 90%) de tétrakis(pentafluorophényl)borate de bisdodécylphényliodonium après évaporation de l'acétone.

### Exemple 4 : (η⁵-cyclopentadiènyle) (η⁶-cumène) Fe⁺ tetrakis (pentafluorophényl)borate

Dans un ballon tricot de 250 ml équipé d'une agitation mécanique, d'un réfrigérant à eau, d'un thermomètre et d'une ampoule de coulée, on charge 4 g (soit 0,0215 mole) de ferrocène, 7,64g de chlorure d'aluminium, 0,11 g d'aluminium en poudre et 27 g de cumène.
L'ensemble est agité et plaçé sous atmosphère inerte d'azote. On chauffe le mélange réactionnel en 2 heures, puis on ajoute goutte à goutte 4,04 g. de chlorure de titane. L'ensemble est chauffé pendant 1 heure à 100°C, puis on laisse revenir doucement le mélange à température ambiante. On verse le mélange réactionnel dans un mélange de 30 g de glace et de 8 g d'HCl à 37,5% ; on laisse 30 mn sous agitation. On ajoute alors 0,7 g d'eau oxygénée; on laisse 30 mn sous agitation, puis on filtre sur un verre fritté n°4. On récupère la fraction liquide; après décantation et séparation des phases, on introduit à la phase aqueuse une solution de 15,4 g de tétrakis(pentafluorophényl)borate de potassium dans 800 ml d'eau ; l'ensemble est laissé sous agitation pendant 2 heures.
Le précipité est séparé par filtration, puis est séché sous vide ; on obtient 14,3 g (soit un rendement de 73%) de produit recherché.

### Exemple 5 : (η⁵-cyclopentadiènyle) (η⁶-toluène) Fe⁺ tétrakis(pentafluorophényl)borate

Dans un ballon tricot de 250 ml contenant 7 g de tétrakis(pentafluorophényl) borate de sodium dissous dans 100 ml d'eau distillée, on ajoute 50 ml d'une solution aqueuse contenant 3,58 g de (η⁵-cyclopentadiènyle) (η⁶-toluène) Fe⁺ hexafluorophosphate. Le mélange est soumis pendant 1 heure à une agitation magnétique. Il se forme un précipité clair que l'on sépare par filtration puis sèche sous vide pendant 24 heures. On obtient ainsi 8,5 g (soit un rendement de 95%) de (η⁵-cyclopentadiènyle) (η⁶-toluène) Fe⁺ tétrakis(pentafluorophényl) borate. La formule du produit obtenu a été confirmée par RMN ¹H, ¹⁹F et par spectrométrie de masse.

### Exemple 6 : (η⁵-cyclopentadiènyle) (η⁶-méthyl1-naphtalène) Fe⁺ tétrakis (pentafluorophényl)borate

On procède comme à l'exemple 4, à partir de 7 g de tétrakis(pentafluorophényl) borate de sodium et de 3,5 g de (η⁵-cyclopentadiènyle) (η⁶-méthyl1-naphtalène) Fe⁺ tétrafluoroborate ; on obtient 8,9 g du produit attendu.
La formule est confirmée par analyse RMN et par spectométris de masse.

### Exemple 7: photoréticulation d'un monomère époxydé en couche mince

Un bain est préparé selon le mode opératoire suivant :
- à 100 parties en poids de monomère époxydé UVR-6110® (3,4-époxy cyclohexylméthyl-3,4-époxycyclohexane carboxylate commercialisé par Union Carbide), on ajoute
- 2 parties en poids de photoamorceur A en solution à 50% en poids dans du méthanol.
Le mélange est maintenu à température ambiante pendant 30 minutes sous agitation mécanique.
Le mélange est ensuite déposé (environ 2 à 3 g/m²) sur du papier glassine (Sibille® 9530 commercialisé par la société SIBILLE) au moyen d'une barre de MAYER® n°0 (commercialisée par la société ERICHSEN G-B).

Le papier enduit passe sous une lampe U.V. de technologie FUSION SYSTEM® F 450 (commercialisée par la société FUSION) et caractérisée par :
- une longueur d'onde de 360 nm,
- une absence d'électrodes,
- une excitation par micro-ondes,
- une puissance de 120 W par cm irradié,
L'énergie d'irradiation mesurée avec une cellule UVICURE® de la société EIT-USA est de 0,025 J. cm-² après un passage sous la lampe U.V. à la vitesse de 33 m/mn..
On note la vitesse de défilement en m/mn nécessaire au durcissement de la couche.
Figurent au tableau 1 le nombre de passages ainsi que les vitesses de défilement du papier; les performances de l'amorceur préparé à l'exemple 1 sont comparées à celles d'un amorceur de cation équivalent mais dont l'anion est choisi parmi ceux de l'art antérieur.
Pour le même cation (Φ)₂ I+, on constate que :
- l'anion B(C₆F₅)₄⁻ est aussi performant que l'anion SbF₆⁻ sans présenter les problèmes de toxicité de ce dernier ;
- l'anion B(C₆F₅)₄⁻ est beaucoup plus actif que les anions ASF₆⁻, PF₆⁻ et BF₄⁻ ;
- les anions B(C₆H₅)₄⁻ et B(C₆H₄F)₄⁻ n'ont aucune efficacité en réticulation du monomère époxydé en couche mince.

**TABLEAU 1**

| **Photoamorceur A** | **Nombre de passages** | **vitesse de défilement en m/mn** |
|---|---|---|
| (Φ)₂ I^{+,} B (C₆F₅)₄ | 1 | 60 |
| (Φ)₂ I^{+,} SbF₆⁻ | 1 | 60 |
| (Φ)₂ I^{+,} AsF₆⁻ | 3 | 20 |
| (Φ)₂ I^{+,} PF₆⁻ | 4 | 15 |
| (Φ)₂ I^{+,} BF₄⁻ | 10 | 6 |
| (Φ)₂ I^{+,} B(C₆H₅)₄⁻ | non réticulé | 0 |
| (Φ)₂ I^{+,} B(C₆H₄F)₄⁻ | non réticulé | 0 |

## Revendications

1. Borates d'onium d'un élément des groupes 15 à 17 de la classification périodique [Chem. & Eng. News, vol 63, n°5, 26 du 4 Février 1985] ou d'un complexe organométallique d'un élément des groupes 4 à 10 de la classification périodique (même référence), caractérisés en ce que l'entité cationique est choisie parmi :
**(1)** - les sels d'onium de formule I
[(R¹)ₙ-A-(R²)ₘ]⁺ (I)
formule dans laquelle :
. A représente un élément des groupes 15 à 17 choisi parmi I, S et Se,
. R¹ représente un radical aryle carbocyclique ou hétérocyclique en C₆-C₂₀, ledit radical hétérocyclique pouvant contenir comme hétéroéléments de l'azote ou du soufre,
. R² représente R¹ ou un radical alkyle ou alkényle linéaire ou ramifié en C₁-C₃₀ ;
lesdits radicaux R¹ et R² étant éventuellement substitués par un groupement alcoxy en C₁-C₂₅, alkyle en C₁-C₂₅, nitro, chloro, bromo, cyano, carboxy, ester ou mercapto,
. n est un nombre entier allant de 1 à v+1, v étant la valence de l'élément A,
. m est un nombre entier allant de 0 à v-1 avec n+m = v+1 ;
**(2)** - les sels d'oxoisothiochromanium de formule : 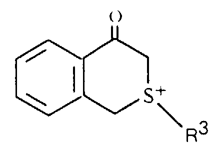 où le radical R³ représente un radical alkyle, linéaire ou ramifié, en C₁-C₂₀ ; (3) - les sels organométalliques de formule Il
(L¹L²L³M)^{+q} (II)
formule dans laquelle :
. M représente un métal du groupe 4 à 10 sélectionné parmi fer, manganèse, chrome et cobalt,
. L¹ représente 1 ligand lié au métal M par des électrons π, ligand choisi parmi les ligands η³-alkyl, η⁵-cyclopentadiényl et η⁷-cycloheptatriényl et les composés η⁶-aromatiques choisis parmi les ligands η⁶-benzène éventuellement substitués et les composés ayant de 2 à 4 cycles condensés, chaque cycle étant capable de contribuer à la couche de valence du métal M par 3 à 8 électrons π ;
. L² représente 1 ligand lié au métal M par des électrons π, ligand choisi parmi les ligands η⁷-cyclohiptatriényl et les composés η⁶-aromatiques choisis parmi les ligands η6-benzène éventuellement substitués et les composés ayant de 2 à 4 cycles condensés, chaque cycle étant capable de contribuer à la couche de valence du métal M par 6 ou 7 électrons π ;
. L³ représente de 0 à 3 ligands identiques ou différents liés au métal M par des électrons σ, ligand(s) choisi(s) parmi CO et NO₂⁺ ; la charge électronique totale q du complexe à laquelle contribuent L¹, L² et L³ et la charge ionique du métal M étant positive et égale à 1 ou 2 ;
et en ce que l'entité anionique borate a pour formule :
[B Xₐ R_{b}]⁻
formule dans laquelle :
- a et b sont des nombres entiers allant de 0 à 4 avec a + b = 4,
- les symboles X représentent :
. un atome d'halogène (chlore, fluor) avec a = 0 à 3,
. une fonction OH avec a = 0 à 2 ,
- les symboles R sont identiques ou différents et représentent :
. un radical phényle substitué par au moins un groupement électroattracteur choisi parmi CF₃, NO₂, CN ou par au moins 2 atomes de fluor, ce lorsque l'entité cationique est un onium d'un élément des groupes 15 à 17,
. un radical phényle substitué par au moins un élément ou un groupement électroattracteur choisi parmi un atome de fluor CF₃, NO₂, CN, ce lorsque l'entité cationique est un complexe organométallique d'un élément des groupes 4 à 10,
. un radical aryle contenant au moins deux noyaux aromatiques, éventuellement substitué par au moins un élément ou un groupement électroattracteur choisi parmi un atome de fluor CF₃, NO₂, CN, quelle que soit l'entité cationique.

2. Borates selon la revendication 1, caractérisés en ce que l'entité anionique est choisie parmi :
[B (C₆F₅)₄]⁻ [B (C₆H₄CF₃)₄]⁻
[(C₆F₅)₂B F₂]⁻ [C₆F₅B F₃]⁻ [B (C₆H₃F₂)₄]⁻

3. Borates selon la revendication 1 ou 2, caractérisés en ce que l'entité cationique est choisie parmi :
[(Φ)₂I]⁺ [C₈H₁₇-O-Φ-I-Φ]⁺
[C₁₂H₂₅-Φ-I-Φ]⁺ [(C₈H₁₇-O-Φ)₂I]⁺ [(C₈H₁₇)-O-Φ-I-Φ)]⁺
[(Φ)₃ S]⁺ [(Φ)₂-S-Φ-O-C₈H₁₇]⁺
[Φ-S-Φ-S(Φ)₂]⁺ [(C₁₂H₂₅-Φ)₂I]⁺
le (η⁵-cyclopentadiényle) (η⁶-toluène) Fe⁺
le (η⁵-cyclopentadiényle) (η⁶-méthyl1-naphtalène) Fe⁺
le (η⁵-cyclopentadiényle) (η⁶-cumène) Fe⁺
le bis (η⁶-mesitylène) Fe⁺
le bis (η⁶-benzène)Cr⁺

4. Borates selon l'une quelconque des revendications 1 à 3, caractérisés en ce que leur formule est choisie parmi :
[(Φ)₂I]⁺, [B (C₆F₅)₄]⁻ [C₈H₁₇-O-Φ-I-Φ]⁺, [B(C₆F₅)₄]⁻
[C₁₂H₂₅-Φ-I-Φ]⁺, [B(C₆F₅)₄]⁻ [(C₈H₁₇-O-Φ)₂I]⁺, [B(C₆F₅)₄]⁻
[(C₈H₁₇)-O-Φ-I-Φ)]⁺, [B (C₆F₅)₄]⁻ [(Φ)₃ S]⁺, [B(C₆F₅)₄]⁻
[(Φ)₂ S-Φ-O-C₈H₁₇]⁺, [B (C₆H₄CF₃)₄]⁻ [(C₁₂H₂₅-Φ)₂I]⁺, [B(C₆F₅)₄]⁻
(η⁵-cyclopentadiényle) (η⁶-toluène) Fe⁺, [B (C₆F₅)₄]⁻
(η⁵-cyclopentadiényle) (η⁶-méthyl1-naphtalène) Fe⁺, [B (C₆F₅)₄]⁻
(η⁵-cyclopentadiényle) (η⁶-cumène) Fe⁺, [B (C₆F₅)₄]⁻

5. Procédé de préparation des borates faisant l'objet de l'une quelconque des revendications 1 à 4 par réaction d'échange entre un sel de l'entité cationique (chlorure, iodure, hexafluorophosphate, tetrafluoroborate, tosylate) avec un sel de métal alcalin (sodium, lithium, potassium) de l'entité anionique.

6. Amorceurs cationiques de polymérisation ou de réticulation par voie photochimique ou sous faisceau d'électrons ou par voie thermique, de monomères ou de polymères à groupements organofonctionnels, lesdits photoamorceurs étant caractérisés en ce qu'ils sont constitués d'un borate faisant l'objet de l'une quelconque des revendications 1 à 4.

7. Utilisation d'un borate d'onium faisant l'objet de l'une quelconque des revendications 1 à 4 comme amorceur cationique de polymérisation ou de réticulation par voie photochimique ou sous faisceau d'électrons ou par voie thermique de monomères ou de polymères à groupements organofonctionnels.

8. Utilisation selon la revendication 7, caractérisée en ce que les monomères ou polymères comprennent des groupements organofonctionnels époxy ou vinyléther.

9. Compositions polymérisables ou réticulables comprenant :
(a) un monomère ou polymère à groupement(s) organofonctionnel(s), polymérisable ou réticulable par activation photochimique, sous faisceau d'électrons ou par voie thermique, et
(b) un borate d'onium faisant l'objet de l'une quelconque des revendications 1 à 4.

10. Compositions selon la revendication 9, caractérisées en ce que le monomère ou polymère comprend un ou plusieurs groupement(s) organofonctionnel(s) époxy ou vinyléther.

## Patentansprüche

1. Borate von Onium eines Elements der Gruppen 15 bis 17 des Periodensystems [Chem. & Eng. News, Vol. 63, Nr. 5, 26 vom 4. Februar 1985] oder eines metallorganischen Komplexes eines Elements der Gruppen 4 bis 10 des Periodensystems (dieselbe Referenz), dadurch gekennzeichnet,
daß die kationische Einheit ausgewählt ist unter:
(1) - den Oniumsalzen der Formel :
[(R¹)ₙ-A-(R²)ₘ]⁺ (I)
eine Formel, in der:
- A ein Element der Gruppen 15 bis 17 darstellt, das unter I, S und Se ausgewählt ist,
- R1 einen carbocyclischen oder heterocyclischen C₆-C₂₀-Arylrest darstellt, wobei besagter heterocyclischer Rest als Heteroelemente Stickstoff oder Schwefel enthalten kann,
- R² R¹ oder einen linearen oder verzweigten C₁-C₃₀-Alkyl- oder -Alkenylrest darstellt,
wobei die Reste R¹ und R² gegebenenfalls mit einer C₁-C₂₅-Alkoxygruppe, C₁-C₂₅-Alkylgruppe, Nitro-, Chloro-, Bromo-, Cyano-, Carboxy-, Ester- oder Mercaptogruppe substituiert sind,
- n eine ganze Zahl ist, die von 1 bis v+1 geht, wobei v die Wertigkeit des Elements A ist,
- m eine ganze Zahl ist, die von 0 bis v-1 geht, mit n+m = v+1;
(2) - den Oxoisothiochromaniumsalzen der Formel: 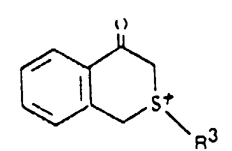 worin der Rest R³ einen linearen oder verzweigten C₁-C₂₀-Alkylrest darstellt;
(3) - den metallorganischen Salzen der Formel II
(L¹L²L³M)^{+q} (II)
eine Formel, in der:
- M ein Metall der Gruppe 4 bis 10 darstellt, das unter Eisen, Mangan, Chrom und Kobalt ausgewählt ist,
- L¹ 1 mit dem Metall M durch π-Elektronen verbundenen Liganden darstellt, wobei der Ligand ausgewählt ist unter den η³-Alkyl-, η⁵-Cydopentadienyl- und η⁷-Cycloheptatrienyl-Liganden und den η⁶-aromatischen Verbindungen, die unter den gegebenenfalls substituierten η⁶-Benzol-Liganden und den Verbindungen mit 2 bis 4 kondensierten Ringen ausgewählt sind, wobei jeder Ring mit 3 bis 8 π-Elektronen zur Valenzschale des Metalls M beitragen kann;
- L² 1 mit dem Metall M durch π-Elektronen verbundenen Liganden darstellt, wobei der Ligand ausgewählt ist unter den η⁷-Cycloheptatrienyl-Liganden und den η⁶-aromatischen Verbindungen, die unter den gegebenenfalls substituierten η⁶-Benzol-Liganden und den Verbindungen mit 2 bis 4 kondensierten Ringen ausgewählt sind, wobei jeder Ring mit 6 oder 7 π-Elektronen zur Valenzschale des Metalls M beitragen kann;
- L³ 0 bis 3 gleiche oder verschiedene Liganden darstellt, die mit dem Metall M durch σ-Elektronen verbunden sind, wobei der(die) Ligand(en) unter CO und NO₂⁺ ausgewählt ist(sind), wobei die gesamte elektronische Ladung q des Komplexes, zu der L¹, L² und L³ beitragen, und die ionische Ladung des Metalls M positiv und gleich 1 oder 2 sind;
und dadurch daß die anionische Borateinheit die Formel:
[BXₐR_{b}]⁻
hat, eine Formel in der:
- a und b ganze Zahlen sind, die von 0 bis 4 gehen, mit a + b = 4,
- die Symbole X darstellen:
- ein Halogenatom (Chlor, Fluor) mit a = 0 bis 3,
- eine OH-Funktion mit a = 0 bis 2,
- die Symbole R gleich oder verschieden sind und darstellen:
- einen Phenylrest, der mit wenigstens einer elektronenziehenden Gruppe, die unter CF₃, NO₂, CN ausgewählt ist, oder mit wenigstens 2 Fluoratomen substituiert ist, wenn die kationische Einheit ein Onium eines Elements der Gruppen 15 bis 17 ist,
- einen Phenylrest, der mit wenigstens einem Element oder einer elektronenziehenden Gruppe, die unter einem Fluoratom, CF₃, NO₂, CN ausgewählt ist, substituiert ist, wenn die kationische Einheit ein metallorganischer Komplex eines Elements der Gruppen 4 bis 10 ist,
- einen Arylrest, der wenigstens zwei aromatische Kerne enthält, der gegebenenfalls mit wenigstens einem Element oder einer elektronenziehenden Gruppe, die unter einem Fluoratom, CF₃, NO₂, CN ausgewählt sind, substituiert ist, wie auch immer die kationische Einheit sein mag.

2. Borate gemäß Anspruch 1, dadurch gekennzeichnet, daß die anionische Einheit ausgewählt ist unter:
[B(C₆F₅)₄]⁻ [B (C₆H₄CF₃)₄]⁻
[(C₆F₅)₂BF₂]⁻ [C₆F₅BF₃]⁻ [B(C₆H₃F₂)₄]⁻.

3. Borate gemäß Anspruch 1 oder 2, dadurch gekennzeichnet, daß die kationische Einheit ausgewählt ist unter:
[(Φ)₂I]⁺ [C₈H₁₇-O-Φ-I-Φ]⁺
[C₁₂H₂₅-Φ-I-Φ]⁺ [(C₈H₁₇-O-Φ)₂I]⁺ [(C₈H₁₇]-O-Φ-I-Φ]⁺
[(Φ)₃S]⁺ [(Φ)₂-S-Φ-O-C₈H₁₇]⁺
[Φ-S-Φ-S(Φ)₂]⁺ [(C₁₂H₂₅-Φ)₂I]⁺
(η⁵-Cyclopentadienyl)(η⁶-toluol)Fe⁺
(η⁵-Cyclopentadienyl)(η⁶-1-methyl-naphthalin)Fe⁺
(η⁵-Cyclopentadienyl)(η⁶-cumol)Fe⁺
Bis(η⁶-mesitylen)Fe⁺
Bis(η⁶-benzol)Cr⁺.

4. Borate gemäß einem der Ansprüche 1 bis 3, dadurch gekennzeichnet, daß ihre Formel ausgewählt ist unter:
[(Φ)₂I]⁺[B(C₆F₅)₄]⁻ [C₈H₁₇-O-Φ-I-Φ]⁺[B(C₆F₅)₄]⁻
[C₁₂H₂₅-Φ-I-Φ]⁺[B(C₆F₅)₄]⁻ [(C₈H₁₇-O-Φ)₂I]⁺[B(C₆F₅)₄]⁻
[(C₈H₁₇)-O-Φ-I-Φ)]⁺[B(C₆F₅)₄]⁻ [(Φ)₃S]⁺[B(C₆F₅)₄]⁻
[(Φ)₂S-Φ-O-C₈H₁₇]⁺[B(C₆H₄CF₃)₄]⁻ [(C₁₂H₂₅-Φ)₂I]⁺[B(C₆F₅)₄]⁻
(η⁵-Cyclopentadienyl)(η⁶-toluol)Fe⁺[B(C₆F₅)₄]⁻
(η⁵-Cyclopentadienyl)(η⁶-1-methyl-naphthalin)Fe⁺[B(C₆F₅)₄]⁻
(η⁵-Cyclopentadienyl)(η⁶-cumol)Fe⁺[B(C₆F₅)₄]⁻.

5. Verfahren zur Herstellung der Borate, die Gegenstand eines der Ansprüche 1 bis 4 sind, durch Austauschreaktion zwischen einem Salz der kationischen Einheit (Chlorid, Iodid, Hexafluorophosphat, Tetrafluoroborat, Tosylat) mit einem Alkalimetallsalz (Natrium, Lithium, Kalium) der anionischen Einheit.

6. Kationische Initiatoren für die Polymerisation oder Vernetzung auf photochemischem Weg oder unter einem Elektronenstrahl oder auf thermischem Weg von Monomeren oder Polymeren mit organofunktionellen Gruppen, wobei besagte Photoinitiatoren dadurch gekennzeicnet sind, daß sie aus einem Borat, das Gegenstand eines der Ansprüche 1 bis 4 ist, bestehen.

7. Verwendung eines Oniumborats, das Gegenstand eines der Ansprüche 1 bis 4 ist, als kationischen Initiator für die Polymerisation oder Vernetzung auf photochemischem Weg oder unter einem Elektronenstrahl oder auf thermischem Weg von Monomeren oder Polymeren mit organofunktionellen Gruppen.

8. Verwendung gemäß Anspruch 7, dadurch gekennzeichnet, daß die Monomere oder Polymere organofunktionelle Epoxy- oder Vinylethergruppen umfassen.

9. Polymerisierbare oder vernetzbare Zusammensetzungen, die umfassen:
(a) ein Monomer oder Polymer mit einer organofunktionellen Gruppe (organofunktionellen Gruppen), das durch photochemische Aktivierung oder unter einem Elektronenstrahl polymerisierbar oder vernetzbar ist, und
(b) ein Oniumborat, das Gegenstand eines der Ansprüche 1 bis 4 ist.

10. Zusammensetzungen gemäß Anspruch 9, dadurch gekennzeichnet, daß das Monomer oder Polymer eine oder mehrere organofunktionelle Epoxy- oder Vinylethergruppe(n) umfaßt.

## Claims

1. Onium borates of an element from groups 15 to 17 of the periodic classification [Chem. & Eng. News, Vol. 63, No. 5, 26; 4 February 1985] or borates of an organometallic complex of an element from groups 4 to 10 of the periodic classification (same reference),
characterized
in that the cationic entity is chosen from:
1) - the onium salts of formula I
[(R¹)ₙ-A-(R²)ₘ]⁺ (I)
in which formula:
• A represents an element from groups 15 to 17 chosen from I, S and Se,
• R¹ represents a C₆-C₂₀ heterocyclic or carbocyclic aryl radical, it being possible for the said heterocyclic radical to contain, as hetero-elements, nitrogen or sulphur,
• R² represents R¹ or a linear or branched, C₁-C₃₀ alkenyl or alkyl radical, the said radicals R¹ and R² optionally being substituted by a C₁-C₂₅ alkoxy, C₁-C₂₅ alkyl, nitro, chloro, bromo, cyano, carboxyl, ester or mercapto group,
• n is an integer ranging from 1 to v+1, v being the valency of the element A,
• m is an integer ranging from 0 to v-1 with n+m = v+1;
2) - the oxoisothiochromanium salts of formula: 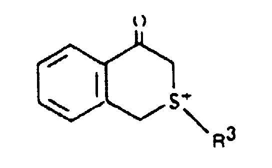 where the radical R³ represents a linear or branched, C₁-C₂₀ alkyl radical;
3) - the organometallic salts of formula II
(L¹L²L³M)^{q+} (II)
in which formula:
• M represents a metal from group 4 to 10 selected from iron, manganese, chromium and cobalt,
• L¹ represents 1 ligand joined to the metal M via π electrons, the ligand being chosen from the η³-alkyl, η⁵-cyclopentadienyl and η⁷-cycloheptatrienyl ligands and the η⁶-aromatic compounds chosen from the optionally substituted η⁶-benzene ligands and the compounds having from 2 to 4 condensed rings, each ring being capable of contributing to the valency layer of the metal M via 3 to 8 π electrons;
• L² represents 1 ligand joined to the metal M via π electrons, the ligand being chosen from the η⁷-cycloheptatrienyl ligands and the η⁶-aromatic compounds chosen from the optionally substituted η⁶-benzene ligands and the compounds having from 2 to 4 condensed rings, each ring being capable of contributing to the valency layer of the metal M via 6 or 7 π electrons;
• L³ represents from 0 to 3 identical or different ligands joined to the metal M via σ electrons, the ligand(s) being chosen from CO and NO₂⁺;
the total electron charge q of the complex to which L¹, L² and L³ and the ionic charge of the metal M contribute being positive and equal to 1 or 2;
and in that the anionic borate entity has the formula:
[BXₐR_{b}]⁻
in which formula:
- a and b are integers ranging from 0 to 4 with a + b = 4,
- the symbols X represent:
• a halogen atom (chlorine or fluorine) with a = 0 to 3,
• an OH functional group with a = 0 to 2,
- the symbols R are identical or different and represent:
• a phenyl radical substituted by at least one electron-withdrawing group chosen from CF₃, NO₂ or CN or by at least 2 fluorine atoms, when the cationic entity is an onium of an element from groups 15 to 17,
• a phenyl radical substituted by at least one electron-withdrawing group or element chosen from a fluorine atom, CF₃, NO₂ or CN, when the cationic entity is an organometallic complex of an element from groups 4 to 10,
• an aryl radical containing at least two aromatic rings, optionally substituted by at least one electron-withdrawing group or element chosen from a fluorine atom, CF₃, NO₂ or CN, whatever the cationic entity.

2. Borates according to claim 1, characterized in that the anionic entity is chosen from:
[B(C₆F₅)₄]⁻ [B(C₆H₄CF₃)₄]⁻
[(C₆F₅)₂BF₂]⁻ [C₆F₅BF₃]⁻ [B(C₆H₃F₂)₄]⁻

3. Borates according to claim 1 or 2, characterized in that the cationic entity is chosen from:
[(Φ)₂I]⁺ [C₈H₁₇-O-Φ-I-Φ]⁺
[C₁₂H₂₅-Φ-I-Φ]⁺ [(C₈H₁₇-O-Φ)₂I]⁺ [(C₈H₁₇)-O-Φ-I-Φ)]⁺
[(Φ)₃ S]⁺ [(Φ)₂-S-Φ-O-C₈H₁₇]⁺
• (η⁵-cyclopentadienyl)(η⁶-toluene)Fe⁺
• (η⁵-cyclopentadienyl) (η⁶-1-methylnaphthalene)Fe⁺
• (η⁵-cyclopentadienyl) (η⁶-cumene)Fe⁺
• bis(η⁶-mesitylene)Fe⁺
• bis(η⁶-benzene)Cr⁺

4. Borates according to any one of claims 1 to 3, characterized in that their formula is chosen from:
[(Φ)₂I]⁺ [B(C₆F₅)₄]⁻ [C₈H₁₇-O-Φ-I-Φ]⁺ [B(C₆F₅)₄]⁻
[C₁₂H₂₅-Φ-I-Φ]⁺ [B(C₆F₅)₄]⁻ [(C₈H₁₇-O-Φ)₂I]⁺ [B(C₆F₅)₄]⁻
[(C₈H₁₇)-O-Φ-I-Φ)]⁺ [B(C₆F₅)₄]⁻ [(Φ)₃S]⁺ [B(C₆F₅)₄]⁻
[(Φ)₂ S-Φ-O-C₈H₁₇]⁺ [B(C₆H₄CF₃)₄]⁻ [(C₁₂H₂₅-Φ)₂I]⁺ [B(C₆F₅)₄]⁻
(η⁵-cyclopentadienyl)(η⁶-toluene)Fe⁺ [B(C₆F₅)₄]⁻
(η⁵-cyclopentadienyl)(η⁶-1-methylnaphthalene)Fe⁺ [B(C₆F₅)₄]⁻
(η⁵-cyclopentadienyl)(η⁶-cumene)Fe⁺ [B(C₆F₅)₄]⁻

5. Process for the preparation of the borates which form the subject of any one of claims 1 to 4, by an exchange reaction between a salt of the cationic entity (chloride, iodide, hexafluorophosphate, tetrafluoroborate or tosylate) and an alkali metal salt (sodium, lithium or potassium) of the anionic entity.

6. Cationic initiators of polymerization or crosslinking, photochemically or under an electron beam or thermally, of monomers or of polymers having organofunctional groups, the said photoinitiators being characterized in that they consist of a borate which forms the subject of any one of claims 1 to 4.

7. Use of an onium borate forming the subject of any one of claims 1 to 4 as cationic initiator of polymerization or crosslinking, photochemically or under an electron beam or thermally, of monomers or of polymers having organofunctional groups.

8. Use according to claim 7, characterized in that the monomers or polymers comprise epoxy or vinyl ether organofunctional groups.

9. Polymerizable or crosslinkable compositions comprising:
(a) a monomer or polymer with organofunctional group(s) which can be polymerized or crosslinked by photochemical activation or under an electron beam, and
(b) an onium borate forming the subject of any one of claims 1 to 4.

10. Compositions according to claim 9, characterized in that the monomer or polymer comprises one or more epoxy or vinyl ether organofunctional group(s).
